# EUROPÄISCHE PATENTSCHRIFT

(11) **EP 3 698 400 B1**
(45) Veröffentlichungstag und Bekanntmachung des Hinweises auf die Patenterteilung: **29.12.2021**
(21) Anmeldenummer: 18807874.5
(22) Anmeldetag: 06.11.2018
(51) Int. Cl.: H01L 23/373

(54) **VERFAHREN ZUM ERZEUGEN EINES KÜHLKÖRPERS AUF EINER ELEKTRONISCHEN BAUGRUPPE**
METHOD FOR PRODUCING A HEAT SINK ON AN ELECTRONIC ASSEMBLY
PROCÉDÉ DE FABRICATION D'UN DISSIPATEUR THERMIQUE SUR UN MODULE ÉLECTRONIQUE

(30) Priorität: 04.12.2017 DE 102017221778
(43) Veröffentlichungstag der Anmeldung: 26.08.2020
(73) Patentinhaber: Siemens Aktiengesellschaft, 80333 München (DE)
(72) Erfinder: REZNIK, Daniel, 13503 Berlin (DE)
(86) Internationale Anmeldenummer: PCT/EP2018/080266
(87) Internationale Veröffentlichungsnummer: WO 2019/110219

(56) Entgegenhaltungen:
- WO-A2-01/45882
- DE-A1-102015 215 570
- GB-A- 2 311 414
- GB-A- 2 327 150

## Beschreibung

Verfahren zum Erzeugen eines Kühlkörpers mit einem additiven Fertigungserfahren

Die Erfindung betrifft ein Verfahren zur Herstellung eines Kühlkörpers mit einem additiven Fertigungsverfahren, bei dem eine Kühlstruktur auf einer Basisplatte additiv erzeugt wird, wobei die Basisplatte einen Teil des Kühlkörpers darstellt.

Es ist bekannt, dass elektronische Baugruppen gekühlt werden müssen. Bei leistungselektronischen Modulen werden beispielsweise Halbleiterchips auf einer Keramikplatte als Substrat aufgebaut. Auf der Rückseite dieses Keramiksubstrates kann ein Kühlkörper befestigt werden, welcher einteilig oder mehrteilig aufgebaut sein kann. Vorzugsweise kann an das Keramiksubstrat eine Bodenplatte angeschlossen werden, beispielsweise durch Löten, wobei die Bodenplatte über Schraubverbindungen mit einem weiteren Kühlkörper verbunden werden kann, um die Kühlleistung zu erhöhen. Hierbei kann es sich um einen passiven Kühler zur Luftkühlung beispielsweise über Rippen oder um einen aktiven Kühler mit einem Kanalsystem für ein Kühlmedium wie Luft, Wasser, einem Wasser-Glykol-Gemisch oder Silikonöl handeln. Um die Verbindung zwischen dem Kühlkörper und der Basisplatte zu verbessern, kann zwischen diesen Bauteilen ein thermisches Übertragungsmedium, wie beispielsweise eine Wärmeleitpaste, vorgesehen werden. Die Wärmeleitfähigkeit einer Wärmeleitpaste ist typischerweise allerdings um 2 Größenordnungen schlechter als die metallischer Werkstoffe.

Aus der DE 10 2015 215 570 A1 ist bekannt, dass ein Kühler mit einem selektiven Laserschmelzen additiv hergestellt werden kann, indem eine Basisplatte verwendet wird, um auf dieser eine Kühlstruktur aufzubauen. Hierbei handelt es sich um eine passive Kühlstruktur mit Kühlkanälen, die jeweils in Kamine münden und so eine Konvektion von Kühlluft begünstigen. Der Kühlkörper ist aus metallischen Werkstoffen gefertigt, um eine gute Wärmeleitung zu gewährleisten. Metallische Werkstoffe lassen sich außerdem gut durch additive Fertigungsverfahren, wie z. B. das Laserschmelzen, herstellen.

Die GB 2 327 150 A offenbart ein Verfahren zum Erzeugen eines Kühlkörpers mit einem Druckgussverfahren, bei dem eine Kühlstruktur auf einer Basisplatte erzeugt wird.

Als additive Fertigungsverfahren im Sinne dieser Anmeldung sollen Verfahren verstanden werden, bei denen das Material, aus dem ein Bauteil hergestellt werden soll, dem Bauteil während der Entstehung hinzugefügt wird. Dabei entsteht das Bauteil bereits in seiner endgültigen Gestalt oder zumindest annähernd in dieser Gestalt. Das Baumaterial kann beispielsweise pulverförmig oder flüssig sein, wobei durch das additive Fertigungsverfahren das Material zur Herstellung des Bauteils chemisch oder physikalisch verfestigt wird.

Als Beispiele für das additive Fertigen können das selektive Lasersintern (auch SLS für Selective Laser Sintering), das Selektive Laserschmelzen (auch SLM für Slective Laser Melting), das Elektronenstrahlschmelzen (auch EBM für Electron Beam Melting), das Laserpulverauftragsschweißen (auch LMD für Laser Metal Deposition), das Kaltgasspritzen (auch GDCS für Gas Dynamic Cold Spray) genannt werden. Diese Verfahren eignen sich insbesondere zur Verarbeitung von metallischen Werkstoffen in Form von Pulvern, mit denen Konstruktionsbauteile hergestellt werden können.

Beim SLM, SLS und EBM werden die Bauteile lagenweise in einem Pulverbett hergestellt. Diese Verfahren werden daher auch als pulverbettbasierte additive Fertigungsverfahren bezeichnet. Es wird jeweils eine Lage des Pulvers in dem Pulverbett erzeugt, die durch die Energiequelle (Laser oder Elektronenstrahl) anschließend in denjenigen Bereichen lokal aufgeschmolzen oder gesintert wird, in denen das Bauteil entstehen soll. So wird das Bauteil sukzessive lagenweise erzeugt und kann nach Fertigstellung dem Pulverbett entnommen werden. Beim LMD und GDCS werden die Pulverteilchen direkt der Oberfläche zugeführt, auf der ein Materialauftrag erfolgen soll. Beim LMD werden die Pulverpartikel durch einen Laser direkt in der Auftreffstelle auf der Oberfläche aufgeschmolzen und bilden dabei eine Lage des zu erzeugenden Bauteils. Beim GDCS werden die Pulverpartikel stark beschleunigt, so dass sie vorrangig aufgrund ihrer kinetischen Energie bei gleichzeitiger Verformung auf der Oberfläche des Bauteils haften bleiben.

GDCS und SLS haben das Merkmal gemeinsam, dass die Pulverteilchen bei diesen Verfahren nicht vollständig aufgeschmolzen werden. Beim GDCS erfolgt ein Aufschmelzen höchstens im Randbereich der Pulverpartikel, die aufgrund der starken Verformung an ihrer Oberfläche anschmelzen können. Beim SLS wird bei Wahl der Sintertemperatur darauf geachtet, dass diese unterhalb der Schmelztemperatur der Pulverpartikel liegt. Demgegenüber liegt beim SLM, EBM und LMD der Energieeintrag betragsmäßig bewusst so hoch, dass die Pulverpartikel vollständig aufgeschmolzen werden.

Ein anderes Problem liegt insbesondere bei Leistungsschaltungen, die auf einem keramischen Substrat aufgebaut sind, darin, dass der auf der Rückseite des keramischen Substrats befestigte Kühler aufgrund der Wahl metallischer Werkstoffe, wie z. B. Aluminium oder Kupfer, einen höheren Wärmeausdehnungskoeffizienten aufweist, als das keramische Substrat. Daher kommt es während des Betriebs zu einer thermischen Verspannung zwischen dem Substrat und dem Kühlkörper, was mit mechanischen Belastungen der Baugruppe verbunden ist.

Die Aufgabe der Erfindung liegt darin, ein Verfahren zum Erzeugen eines Kühlkörpers mit einem additiven Fertigungserfahren anzugeben, das es ermöglicht, dass sich einerseits möglichst geringe mechanische Belastungen bei einer Erwärmung des Kühlkörpers und der zu kühlenden Komponente ergeben und andererseits eine gute Wärmeableitung aus der zu kühlenden Komponente in den Kühlkörper realisieren lässt.

Ein Kühlkörper, der mit dem erfindungsgemäßen Verfahren hergestellt wird, kann so ausgestaltet sein, dass die Basisplatte aus einem eine keramische Phase und eine metallische Phase aufweisenden Metall-Keramik-Verbundwerkstoff besteht und die Kühlstruktur aus einem Metall oder einer Metalllegierung besteht, wobei zwischen der Kühlstruktur und der metallischen Phase der Basisplatte eine rein metallische Verbindung ausgebildet ist. Diese rein metallische Verbindung kann eine Schweißverbindung, eine Lötverbindung oder eine Sinterverbindung sein. Hierdurch ist vorteilhaft gewährleistet, dass zwischen der Basisplatte und der Kühlstruktur ein guter Wärmeübergang stattfinden kann. Dieser Wärmeübergang wird beispielsweise nicht durch einen Montagespalt gestört und auch nicht durch materialbedingte Phasenübergänge, wenn in dem Montagespalt beispielsweise eine Wärmeleitpaste vorgesehen wird. Besonders vorteilhaft ist die Ausbildung einer Schweißverbindung, da die metallische Phase der Basisplatte mit dem Material der Kühlstruktur eine Phase bildet und daher ein Phasenübergang in der Schweißverbindung nicht mehr vorhanden ist. Hierdurch kann der Wärmefluss aus der metallischen Phase der Basisplatte ungehindert in die Kühlstruktur erfolgen, da Phasenübergänge einen zusätzlichen thermischen Widerstand erzeugen würden. Unter Phasenübergängen sollen im Zusammenhang mit dieser Anmeldung immer Übergänge von einem Material in ein anderes Material verstanden werden. Phasenübergänge innerhalb eines Materials, beispielsweise durch Korngrenzen, sollen im Zusammenhang mit dieser Anmeldung nicht diskutiert werden.

Gemäß einer Ausgestaltung eines Kühlkörpers kann die metallische Verbindung durch einen metallischen Fügehilfsstoff ausgebildet werden. Dies ist insbesondere bei Lötverbindungen üblich, bei denen als metallischer Fügehilfsstoff ein Lotmaterial in den Spalt zwischen den zu verbindenden Bauteilen gegeben wird. Hierdurch ist eine Verbindung zwischen der metallischen Phase der Basisplatte und der Kühlstruktur möglich.

Selbstverständlich erfolgt in dem Kühlkörper auch ein Wärmeübergang zwischen der keramischen Phase der Basisplatte und der Kühlstruktur, und zwar soweit die keramische Phase mit der Kühlstruktur in Kontakt steht. Allerdings wird die Funktion einer Wärmeleitung hauptsächlich durch die metallische Phase der Basisplatte gewährleistet.

Das Vorsehen einer keramischen Phase in der Basisplatte hat hingegen den Vorteil, dass die Basisplatte hinsichtlich ihres Ausdehnungskoeffizienten an keramische Substrate, welche an der Montagefläche des Kühlkörpers montiert werden können, angepasst ist. Hierdurch lassen sich vorteilhaft die mechanischen Spannungen bei einer Erwärmung einer Baugruppe, bestehend aus dem Kühlkörper und einer zu kühlenden Komponente, wie z. B. einer leistungselektronischen Schaltung mit einem Keramiksubstrat, verringern. Gleichzeitig gewährleistet die metallische Phase der Basisplatte wegen der metallischen Anbindung der Kühlstruktur eine gute Wärmeleitung, so dass der Kühlkörper die Vorteile eines an Keramiken angepassten Wärmeausdehnungsverhaltens an der Montagefläche mit einer guten Kühlleistung verbindet.

Die elektronische Komponente kann beispielsweise aus einem Keramiksubstrat zum Aufbau einer leistungselektronischen Schaltung bestehen. Es können vorteilhaft jedoch auch elektronische Bauelemente selbst direkt an die Montagefläche des Kühlkörpers angeschlossen werden. Handelt es sich bei diesen Bauelementen um Halbleiterbauelemente, so profitieren diese ebenfalls von einer Anpassung des Wärmeausdehnungskoeffizienten an der Montagefläche des Kühlkörpers, da diese ebenfalls einen geringeren Wärmeausdehnungskoeffizienten als Metalle aufweisen.

Als Basisplatte kann insbesondere ein Metall-Matrix-Komposit Verwendung finden. Bei diesem bildet das Metall eine Matrix, in der Keramikpartikel eingebettet sind. Die Wärmeleitung erfolgt dann vorteilhaft hauptsächlich über die metallische Matrix, so dass vorteilhaft keine Phasengrenzen im Inneren der Basisplatte überwunden werden müssen. Als Metall-Matrix-Komposit kann vorzugsweise ein Komposit aus Aluminium und Siliziumcarbid (AlSiC) Verwendung finden. Die Herstellung erfolgt durch Kompaktierung eines Siliziumcarbidpulvers, welches anschließend mit flüssigem Aluminium infiltriert wird, welches dann in die Zwischenräume eindringt und so ein porenfreies Kompositmaterial bildet. Auf diese Weise können selbstverständlich auch Metall-Matrix-Komposite aus anderen Materialien hergestellt werden, so dass durch Wahl eines geeigneten Pulvers eine gute Anpassung des Wärmeausdehnungskoeffizienten an die zu kühlende Komponente erfolgen kann.

Weiterhin kann die metallische Phase der Basisplatte und die Kühlstruktur aus demselben metallischen Werkstoff oder aus Metalllegierungen mit demselben Basislegierungsanteil bestehen. Wie bereits erläutert, kann hierdurch vorteilhaft erreicht werden, dass nach dem Verbinden der Kühlstruktur mit der metallischen Phase der Basisplatte kein Phasenübergang in der rein metallischen Verbindung mehr besteht, so dass eine besonders gute Wärmeleitung am Übergang zwischen der Basisplatte und der Kühlstruktur gewährleistet ist. Zur Erlangung dieses Vorteils ist es nicht erforderlich, dass in der Basisplatte und der Kühlstruktur identische Metalllegierungen verwendet werden. Vielmehr reicht es, wenn diese denselben Basislegierungsanteil aufweisen, wobei als Basislegierungsanteil im Sinne der Erfindung derjenige Legierungsanteil der Metalllegierung verstanden werden soll, der den größten Legierungsanteil in der Legierung aufweist. Als metallische Werkstoffe können weiterhin auch reine Metalle verwendet werden, wobei diese ebenfalls geringe Legierungsanteile oder Verunreinigungen aufweisen können. Als reine Metalle bzw. Basislegierungsanteile eignen sich wegen der sehr guten Wärmeleiteigenschaften insbesondere Aluminium, Kupfer und Silber, wobei Aluminium vorteilhaft hier die kostengünstigste Alternative darstellt.

Weiterhin kann die Kühlstruktur mit Rippen oder Noppen ausgestattet ist. Dies sind geometrische Strukturen, die die Oberfläche der Kühlstruktur vergrößern und somit eine Wärmeabgabe verbessern. Dabei können die Rippen oder Noppen Teil eines Luftkühlers sein, so dass die Wärme an die Umgebungsluft abgegeben wird. Eine andere Möglichkeit besteht darin, die Rippen und Noppen in einem flüssigen Kühlmedium anzuordnen. Vorteilhaft ist es nämlich, in der Kühlstruktur einen Kanal für ein Kühlmedium auszubilden, so dass dieses zwangsgeführt werden kann. Dies führt vorteilhaft zu einem schnelleren Austausch des Kühlmediums. Insbesondere kann auch ein flüssiges Kühlmedium Verwendung finden. In diesem Fall muss der Kanal nach außen geschlossen sein, damit kein Verlust des flüssigen Kühlmediums auftritt. In dem Kanal können außerdem vorteilhaft die Rippen oder Noppen angeordnet sein.

Alternativ wird die genannte Aufgabe auch mit einer elektronischen Baugruppe mit einem Schaltungsträger dadurch gelöst, dass der Schaltungsträger aus einem keramischen Werkstoff besteht und der Schaltungsträger auf einer Montageseite eines nach den vorstehend erläuterten Bauprinzipien ausgebildeten Kühlkörpers befestigt ist. Vorteilhaft ist das Wärmeausdehnungsverhalten des Kühlkörpers an der Montagfläche an dem Wärmeausdehnungskoeffizienten des Schaltungsträgers angepasst oder zumindest angenähert, so dass es bei einer Erwärmung der elektronischen Baugruppe zu geringeren mechanischen Spannungen kommt. Gleichzeitig ist über die metallische Phase der Basisplatte eine gute Wärmeleitung in die Kühlstruktur des Kühlkörpers möglich (wie bereits erläutert).

Die Aufgabe wird erfindungsgemäß auch durch das eingangs angegebene Verfahren zum additiven Erzeugen eines Kühlkörpers gelöst, indem die Basisplatte aus einem eine keramische Phase und eine metallische Phase aufweisenden Metall-Keramik-Verbundwerkstoff besteht und die Kühlstruktur aus einem Metall oder einer Metalllegierung hergestellt wird, wobei zwischen dem Material der Kühlstruktur und der metallischen Basisplatte während des Verfestigens des Materials der Kühlstruktur eine rein metallische Verbindung ausgebildet wird. Hierbei handelt es sich vorzugsweise um eine Schweißverbindung, wenn beispielsweise ein SLS oder EBM oder ein LMD als additives Fertigungsverfahren angewendet wird. Beim GDCS wird eine Kaltschweißverbindung erzeugt. Beim SLS kommt es wegen des geringeren Energieeintrags als beim SLM zum Ausbilden einer Sinterverbindung.

Mit dem erfindungsgemäßen Verfahren lassen sich Kühlkörper herstellen, die die oben beschriebenen Vorteile aufweisen (angepasster Wärmeausdehnungskoeffizient verbunden mit einem guten Wärmeleitungsverhalten). Durch Wahl des additiven Fertigungsverfahrens lässt sich überdies vorteilhaft ein hoher Grad der Individualisierung des Kühlkörpers am konkreten Einsatzfall realisieren. So können beispielsweise Standardmodule mit einer Metall-Keramik-Basisplatte umgearbeitet werden, um beispielsweise einen geschlossenen Kühlkanal aufzubauen. Außerdem kann der Kühlkanal hinsichtlich der herrschenden Strömungsverhältnisse optimiert werden, da mit additiven Fertigungsverfahren auch komplexe Strukturen ohne Vergrößerung des Fertigungsaufwandes hergestellt werden können. Dabei können beispielsweise Totvolumina im Kühlkanal vermieden werden, in denen eine Zirkulation des Kühlfluids verringert wäre. Gleichzeitig können Teilbereiche des Kühlkörpers, in denen eine größere Wärmemenge eingeleitet wird (abhängig von der zu kühlenden Komponente), derart ausgebildet werden, dass hier ein größerer Wärmeübergang erfolgen kann (vergrößerte Strömungsgeschwindigkeit des Kühlfluids, vergrößertes Angebot an Kühlfläche der Kühlstruktur).

Gemäß einer Ausgestaltung des erfindungsgemäßen Verfahrens kann die Basisplatte in eine Anlage zum additiven Fertigen des Kühlkörpers eingelegt werden und die Kühlstruktur additiv auf der Basisplatte hergestellt werden. Hierbei wird die Basisplatte als kostengünstiges Halbzeug verwendet, um die Kühlstruktur direkt auf dieser herzustellen. Durch das additive Fertigen wird gleichzeitig die rein metallische Verbindung zwischen der Kühlstruktur und der metallischen Phase der Basisplatte ausgebildet. Dies kann insbesondere durch ein SLM oder ein EBM erfolgen, weil diese Verfahren ein Verschweißen der metallischen Phase mit dem Material der Kühlstruktur gewährleisten. Allerdings kann der Übergang auch durch Sintern (SLS) oder Kaltverschweißen (CGDS) geschaffen werden.

Gemäß einer besondere Ausgestaltung der Erfindung ist vorgesehen, dass auf der Basisplatte eine elektronische Schaltung vormontiert ist. Diese elektronische Schaltung kann dann in die Anlage zum additiven Fertigen eingelegt werden, wobei die Basisplatte mit der Seite, auf der die elektronische Schaltung nicht vormontiert ist, derart in die Anlage eingebracht wird, dass diese Seite für den additiven Aufbau der Kühlstruktur zugänglich ist. Auf diese Weise können vorteilhaft elektronische Schaltungen hinsichtlich ihres Kühlverhaltens modifiziert werden, wenn diese nach der Inbetriebnahme der elektronischen Schaltung nicht den Anforderungen entspricht.

Gemäß einer weiteren Ausgestaltung ist vorgesehen, dass die Basisplatte als Teil eines leistungselektronischen Moduls ausgeführt ist. Ein derartiges Modul kann bevorzugt folgende Eigenschaften aufweisen.

Das Modul kann hermetisch verschlossen sein. Normalerweise geschieht dies durch eine Kombination aus einem inneren Weichverguss, äußeren Hartverguss und äußeren Hülle aus Kunststoff. Aus dem Modul werden Last- und Steuerkontakte herausgeführt, wobei der Spannungsklasse entsprechende Isolationsabstände berücksichtigt werden müssen.

Das Modul wird vom Hersteller statisch und dynamisch getestet. Damit ist das Modul bereits einsatzfähig.

Das Modul ist normalerweise eine in großer Stückzahl hergestellte Standardkomponente. Erfindungsgemäß ist vorgesehen, dass diese individualisiert werden kann, indem der Kühlkörper additiv auf die Basisplatte aufgebaut wird. Dabei kann sichergestellt werden, dass die Funktion des Moduls in der vorgegebenen Qualität gegeben ist. Der Aufbau der Kühlstruktur führt dabei vorteilhaft nicht zu einer Erzeugung von Ausschuss. Würde erst der Kühlkörper mit Basisplatte hergestellt werden, und auf diesem anschließend die Schaltung realisiert, könnte es demgegenüber nämlich noch zu einem Ausschuss aufgrund von Qualitätsmängeln der elektronischen Schaltung kommen.

Gemäß einer anderen Ausgestaltung der Erfindung ist es auch möglich, dass die Basisplatte in der Anlage zum additiven Fertigen aus einem Gemisch eines keramischen Materials und eines metallischen Materials additiv hergestellt wird. Dabei wird das metallische Material geschmolzen oder versintert, da dieses einen geringeren Schmelzpunkt aufweist als das keramische Material. Auf diese Weise entsteht der metall-keramische Verbundwerkstoff, aus dem die Basisplatte besteht. Ist die Basisplatte fertiggestellt, so wird das Aufbaumaterial in der Anlage gewechselt und mit einem metallischen Material die Kühlstruktur aufgebaut. Dieses Verfahren hat den Vorteil, dass der Kühlkörper individuell an den Einsatzfall angepasst werden kann. Insbesondere kann auch die Geometrie der Montageseite auf eine bestimmte elektronische Baugruppe zugeschnitten werden. Dies ist insbesondere von Vorteil, wenn der Kühlkörper auf einzelne Bauelemente aufgesetzt werden soll, wobei hierfür geometrisch angepasste Aufnahmen gestaltet werden können.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
- Figur 1: ein Ausführungsbeispiel des erfindungsgemäßen Verfahrens in einer Anlage zum selektiven Laserschmelzen, teilweise geschnitten,
- Figur 2 und 3: Ausführungsbeispiele des Kühlkörpers als Seitenansicht,
- Figur 4: ein Ausführungsbeispiel der elektronischen Baugruppe mit einem Ausführungsbeispiel des Kühlkörpers, teilweise geschnitten und
- Figur 5: das Detail V gemäß Figur 3 geschnitten.

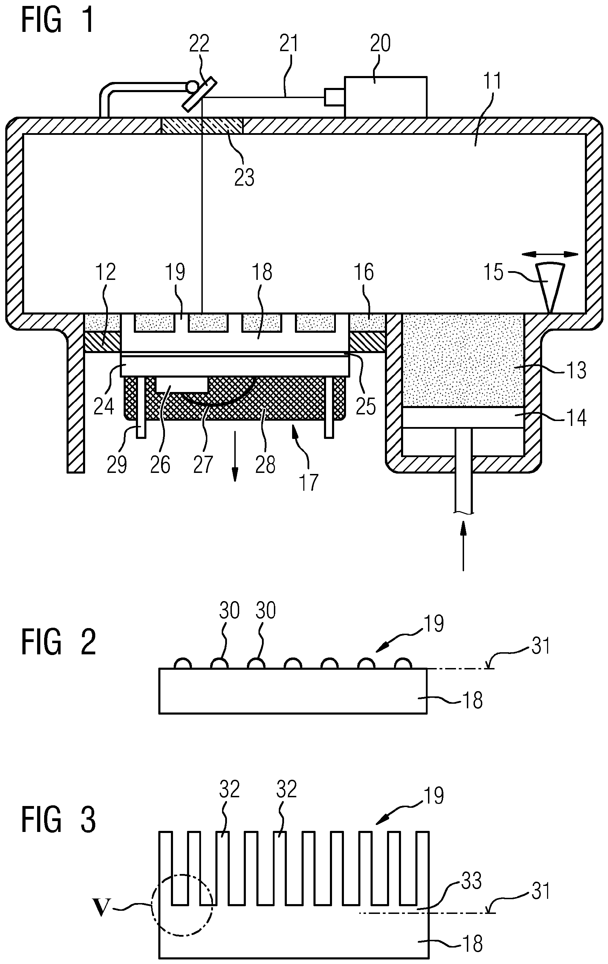

In Figur 1 ist eine Anlage dargestellt, mit der ein SLM durchgeführt werden kann. Diese Anlage weist eine Prozesskammer 11 auf, in der eine Bauplattform 12 zur Herstellung einer additiven Struktur vorgesehen ist. Außerdem steht ein Pulvervorrat 13 zur Verfügung. Der Pulvervorrat 13 kann mit Hilfe eines Dosierzylinders 14 in Richtung der Prozesskammer angehoben werden, wodurch Pulver zur Verfügung gestellt wird, welches mittels einer Verteilvorrichtung 15 (beispielsweise einer Rakel) als Lage auf einem Pulverbett 16 verteilt werden kann.

Die Bauplattform 12 ist zur Aufnahme einer elektronischen Baugruppe 17 geeignet, welche mit einer Basisplatte 18, die Teil der elektronischen Baugruppe 17 ist, von der Bauplattform 12 gehalten werden kann. Daher ist es möglich, auf der Basisplatte eine Kühlstruktur 19 aufzubauen, indem das Material des Pulverbetts 16 verfestigt, zum Beispiel aufgeschmolzen wird. Hierzu produziert ein Laser 20 einen Laserstrahl 21, der über einen Umlenkspiegel 22 durch ein Fenster 23 in die Prozesskammer 11 umgelenkt wird und Partikel des Pulverbetts 16 aufschmilzt. So wird die Kühlstruktur Lage für Lage hergestellt, indem die Bauplattform 12 mit der elektronischen Baugruppe 17 schrittweise abgesenkt wird und mit der Verteilvorrichtung 15 immer neue Lagen im Pulverbett 16 erzeugt werden.

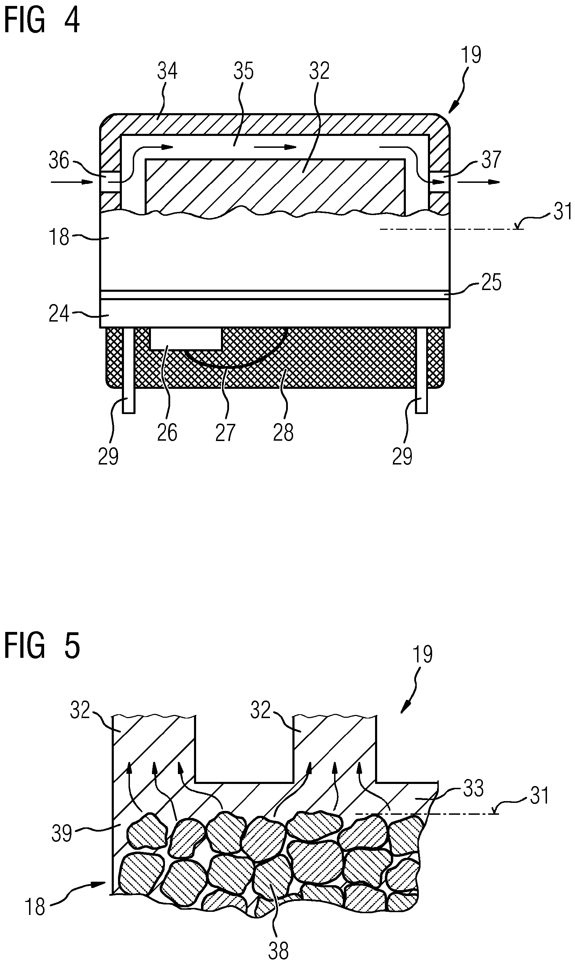

Die Basisplatte 18 stellt einen Teil der elektronischen Baugruppe 17 dar und ist aus einem Metall-Keramik-Verbund, insbesondere aus AlSiC gebildet. Die Anbindung der Kühlstruktur 19 erfolgt an der Grenzfläche zur Basisplatte 18 durch Aufschmelzen und somit Verschweißen des Materials (hierzu im Folgenden zu Figur 5 noch mehr).

Die elektronische Baugruppe besteht weiterhin aus einem keramischen Substrat 24, welches über eine nicht näher dargestellte Kupfermetallisierung auf beiden Seiten verfügt. Daher können das Substrat 24 und die Basisplatte 18 über eine Lötverbindung aus einem Fügehilfsstoff 25 (hier Lotwerkstoff) miteinander verbunden werden. Auf der der Basisplatte 18 gegenüberliegenden Montageseite des Substrats 24 ist ein elektronisches Bauelement 26 in Form eines Leistungshalbleiters montiert, wobei dies über eine nicht näher dargestellte Lötverbindung erfolgt ist. Außerdem ist eine Bondverbindung 27 zwischen dem Bauelement 26 und dem Substrat 24 vorgesehen. Die elektronische Schaltung ist außerdem durch eine Vergussmasse 28 versiegelt, wobei elektrische Kontaktstifte 29 aus der Vergussmasse 28 herausragen und in nicht näher dargestellter Weise zur elektrischen Kontaktierung des Bauelements 26 dienen.

Gemäß Figur 2 ist ein weiterer Kühlkörper dargestellt. Dieser weist eine Basisplatte 18 auf, auf der Noppen 30 durch additives Herstellen als Kühlstruktur 19 gefertigt wurden. Die Noppen 30 vergrößern die Oberfläche des Kühlkörpers bessern dadurch seine Kühlleistung. Zu erkennen ist weiterhin eine Ebene 31, in der der Übergang zwischen dem Basisplatte 18 und der Kühlstruktur 19 liegt.

Gemäß Figur 3 ist eine andere Bauform des Kühlkörpers dargestellt. Diese weist Rippen 32 auf, die durch die Kühlstruktur 19 ausgebildet werden. Die Kühlstruktur besteht jedoch nicht nur aus den Rippen 32, sondern auch aus einer auf der Basisplatte aufgebrachten Schicht 33. Diese Schicht 33 hat die Funktion, durch eine großflächige Anbindung an die Basisplatte 18 die über die metallische Phase der Basisplatte 18 geleitete Wärme gleichmäßig auf die Rippen 32 zu verteilen. Ansonsten könnte die Wärme aus der Basisplatte 18 in den Zwischenräumen zwischen den Rippen 32 nur unter erschwerten Bedingungen abgeführt werden. Ein Übergang zwischen der Basisplatte 18 und der Schicht 33 liegt in der Ebene 31.

Gemäß Figur 4 ist eine elektronische Baugruppe 17 dargestellt, die derjenigen gemäß Figur 1 entspricht. Der Kühlkörper weist jedoch Besonderheiten auf, die im Folgenden näher erläutert werden sollen.

Der Kühlkörper weist Rippen 32 auf, von denen eine im Längsschnitt dargestellt ist. Vor und hinter der Zeichenebene gemäß Figur 4 liegen weitere nicht erkennbare Rippen. Außerdem wird der Kühlkörper 19 durch eine Gehäusestruktur 34 ergänzt, welche ebenfalls wie die Rippen 32 direkt auf der Basisplatte 18 hergestellt ist. Auf diese Weise ergibt sich eine dichte Kavität, die als Kanal 35 zur Durchleitung eines Kühlfluids wie beispielsweise Wasser genutzt werden kann. Zu diesem Zweck sind in der Gehäusestruktur ein Einlass 36 und ein Auslass 37 vorgesehen. Der Fluss des Kühlmediums ist durch Pfeile angedeutet.

In Figur 5 ist der Ausschnitt V gemäß Figur 3 dargestellt. In der Schnittdarstellung wird deutlich, dass die Basisplatte 18 aus einem Metall-Matrix-Komposit besteht, bei dem keramische Partikel beispielsweise aus Siliziumkarbid eine keramische Phase 38 bilden, die von einer metallischen Matrix aus Aluminium umgeben ist, welche eine metallische Phase 39 bildet. Die metallische Phase dient daher vorteilhaft dazu, dass in der Basisplatte 18 Wärme gut zu der Kühlstruktur 19 geleitet werden kann. Andererseits sorgt der verhältnismäßig hohe Füllgrad der keramischen Phase 38 dafür, dass das Wärmeausdehnungsverhalten der Basisplatte demjenigen eines keramischen Substrats 24, welches mit dem Fügehilfsstoff 25 gemäß Figur 4 an die Basisplatte angebunden werden kann, angeglichen ist.

Mechanische Spannungen entstehen dafür an der Grenze zwischen der Basisplatte 18 und der Kühlstruktur 19 in der Ebene 31, wo eine Phasengrenze nicht mehr zu erkennen ist, weil das metallische Material der Kühlstruktur 19 durch Laserschmelzen mit der metallischen Phase 39 der Basisplatte verschmolzen wurde. Allerdings ist die Stabilität und die Elastizität der metallischen Phase 39 sowie der Kühlstruktur 19 ausreichend, um diese wärmedehnungsbedingten Spannungen zu ertragen, wobei die Basisplatte 18 dick genug ausgeführt ist, damit die entstehenden Spannungen bis zur in Figur 5 nicht dargestellten Montagefläche des Kühlkörpers abgebaut werden. (Dies gilt auch für die Basisplatten der Kühlkörper gemäß den Figuren 1, 2 und 4).

Zu erkennen ist in Figur 5 auch die Schicht 33, die für eine vollflächige Anbindung der Kühlstruktur 19 an die Basisplatte 18 geeignet ist und die Rippen 32 zusätzlich stabilisiert. Die Schicht 33 vergrößert somit die mechanische Stabilität des Kühlkörpers und verbessert überdies die Wärmeeinleitung von der Basisplatte 18 in die Kühlstruktur 19, da in der Ebene 31 hierzu die größtmögliche Oberfläche zur Verfügung steht (angedeutet ist der Wärmefluss gemäß Figur 5 durch Pfeile).

## Patentansprüche

1. Verfahren zum Erzeugen eines Kühlkörpers mit einem additiven Fertigungserfahren, bei dem eine Kühlstruktur (19) auf einer Basisplatte (18) additiv erzeugt wird,
wobei die Basisplatte (18) aus einem eine keramische Phase (38) und eine metallische Phase (39) aufweisenden Metall-Keramik-Verbundwerkstoff besteht und die Kühlstruktur (19) aus einem Metall oder einer Metalllegierung hergestellt wird, und wobei zwischen dem Material der Kühlstruktur (19) und der metallischen Phase (39) der Basisplatte (18) während des Verfestigens des Materials der Kühlstruktur (19) eine rein metallische Verbindung ausgebildet wird,
wobei die Basisplatte (18) in eine Anlage zum additiven Fertigen des Kühlkörpers eingelegt wird und die Kühlstruktur (19) additiv auf der Basisplatte hergestellt wird wobei auf der Basisplatte (18) eine elektronische Schaltung vormontiert ist.

2. Verfahren nach Anspruch 1,
**dadurch gekennzeichnet,**
**dass** die Basisplatte (18) als Teil eines leistungselektronischen Moduls ausgeführt ist.

3. Verfahren nach Anspruch 2,
**dadurch gekennzeichnet,**
**dass** die Basisplatte (18) in der Anlage zum additiven Fertigen aus einem Gemisch eines keramischen Materials und eines metallischen Materials additiv hergestellt wird.

4. Verfahren nach einem der vorhergehenden Ansprüche,
**dadurch gekennzeichnet,**
**dass** als additives Fertigungsverfahren ein selektives Laserschmelzen oder ein Elektronenstrahlschmelzen durchgeführt wird.

## Claims

1. Method of producing a heat sink by an additive manufacturing method, in which a cooling structure (19) is additively manufactured on a base plate (18),
wherein the base plate (18) consists of a metal-ceramic composite including a ceramic phase (38) and a metallic phase (39), and the cooling structure (19) is produced from a metal or a metal alloy, and wherein a purely metallic bond is formed between the material of the cooling structure (19) and the metallic phase (39) of the base plate (18) during the solidifying of the material of the cooling structure (19), wherein the base plate (18) is inserted into a system for additively manufacturing the heat sink and the cooling structure (19) is additively manufactured on the base plate, wherein an electronic circuit has been premounted on the base plate (18).

2. Method according to Claim 1,
**characterized in that**
the base plate (18) is designed as part of a power electronics module.

3. Method according to Claim 2,
**characterized in that**
the base plate (18) is additively manufactured in the system for additive manufacture from a mixture of a ceramic material and a metallic material.

4. Method according to any of the preceding claims,
**characterized in that**
the additive manufacturing method performed is a selective laser melting method or an electron beam melting method.

## Revendications

1. Procédé de production d'un puits de chaleur par un procédé de fabrication additif, dans lequel on produit additivement une structure (19) de refroidissement sur une plaque (18) de base, dans lequel la plaque (18) de base est en un matériau composite métal-céramique ayant une phase (38) céramique et une phase (39) métallique et on fabrique la structure (19) de refroidissement en un métal ou en un alliage métallique, et dans lequel on constitue, entre le matériau de la structure (19) de refroidissement et la phase (39) métallique de la plaque (18) de base pendant la consolidation du matériau de la structure (19) de refroidissement une liaison purement métallique,
dans lequel on insère la plaque (18) de base dans une installation de fabrication additive du puits de chaleur et on produit la structure (19) de refroidissement additivement sur la plaque de base, un circuit électronique étant monté à l'avance sur la plaque (18) de base.

2. Procédé suivant la revendication 1,
**caractérisé**
**en ce que** la plaque (18) de base est réalisée sous la forme d'une partie d'un module électronique de puissance.

3. Procédé suivant la revendication 2,
**caractérisé**
**en ce que** l'on produit additivement la plaque (18) de base de l'installation de fabrication additive en un mélange d'un matériau céramique et d'un matériau métallique.

4. Suivant l'une quelconque des revendications précédentes, **caractérisé**
**en ce que** l'on effectue comme procédé de fabrication additive une fusion laser sélective ou une fusion par faisceau d'électrons.
